# EUROPEAN PATENT APPLICATION

(11) **EP 4 663 669 A1**
(43) Date of publication of application: **17.12.2025**
(21) Application number: 23921374.7
(22) Date of filing: 22.12.2023
(51) Int. Cl.: C08F 289/00, B32B 15/08, B32B 27/18, C08F 2/44, C08J 5/10, C09J 11/06, C09J 201/00, C09K 21/12, H05K 1/03

(54) **FLAME RETARDANT AND USE THEREOF**

(30) Priority: 07.02.2023 JP 2023016517
(71) Applicant: SHIKOKU CHEMICALS CORPORATION, Marugame-shi, Kagawa 763-8504 (JP)
(72) Inventor: KASHIWABARA, Takashi, Ayauta-gun, Kagawa 769-0202 (JP); SHIOIRI, Ryosuke, Ayauta-gun, Kagawa 769-0202 (JP); AOKI, Kazunori, Ayauta-gun, Kagawa 769-0202 (JP); YAMAKITA,Yuichi, Ayauta-gun, Kagawa 769-0202 (JP); KUMANO, Takeshi, Ayauta-gun, Kagawa 769-0202 (JP)
(74) Representative: Müller-Boré & Partner Patentanwälte PartG mbB
(86) International application number: PCT/JP2023/046160
(87) International publication number: WO 2024/166556

(57) **Abstract**

The present invention provides a flame retardant containing a phosphorus compound and its use. Specifically, the present invention provides a flame retardant containing a phosphorus compound represented by chemical formula (I), a resin composition containing the flame retardant and a resin component, a prepreg containing the resin composition, metal foil with resin, a thermosetting resin film, a metal-clad laminate, a printed wiring board, and an adhesive: 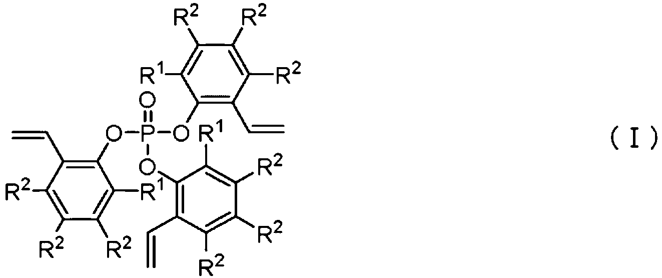 wherein each R¹ is the same or different and represents hydrogen or C₁₋₁₀ alkyl, and each R² is the same or different and represents hydrogen or C₁₋₁₀ alkyl.

## Description

### Technical Field

The present invention relates to a flame retardant containing a phosphorus compound and to its use.

### Background Art

In recent years, electronic devices have been decreasing in size and their performance has been improving, and multiple build-up layers have been formed in multilayer printed wiring boards, requiring miniaturization and high density of wiring.

In particular, in high-frequency applications, there is a demand for an insulating material (resin material) with a low dielectric tangent in order to reduce transmission loss of electrical signals. Such a resin material is required to have flame retardancy after curing in addition to electrical properties, and various flame retardants are being researched.

As conventional flame retardants, phosphorus compounds represented by chemical formula (V) or (VI) are known **(e.g.,** Patent Literature (PTL) 1). These phosphorus compounds have a reactive group (vinyl or allyl) and a phosphorus atom in the molecule.

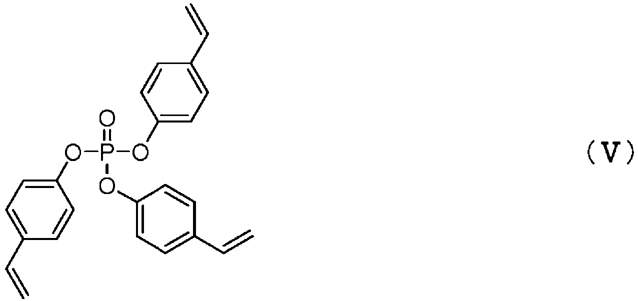

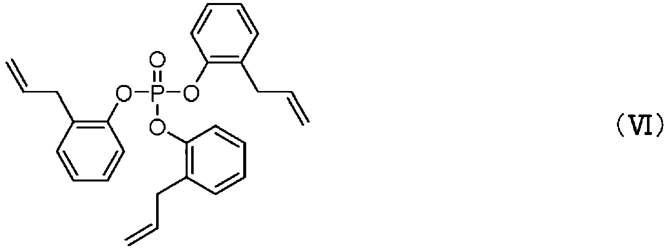

Although cured products of resin compositions containing these phosphorus compounds exhibit excellent flame retardancy, electrical properties, and heat resistance, there has still been room for improvement in electrical properties and heat resistance. In addition, these phosphorus compounds also have a problem of having low resistance to hydrolysis.

### Citation List

### Patent Literature

PTL 1: CN109762115A

### Summary of Invention

### Technical Problem

An object of the present invention is to provide a flame retardant containing a phosphorus compound and use of the flame retardant. Specifically, an object of the present invention is to provide a flame retardant containing a specific phosphorus compound, a resin composition containing the flame retardant and a resin component, a prepreg containing the resin composition, a metal foil with resin, a thermosetting resin film, a metal-clad laminate, a printed wiring board, and an adhesive.

### Solution to Problem

As a result of repeated extensive study to solve the above problems, the present inventors found that a phosphorus compound having three o-vinylphenyl groups is useful as a flame retardant and that a resin composition containing the flame retardant and a resin component is useful as a material for prepreg, metal foil with resin, thermosetting resin films, metal-clad laminates, printed wiring boards, and adhesives. The present inventors conducted further study based on these findings and completed the present invention.

Specifically, a first invention relates to a flame retardant comprising a phosphorus compound represented by chemical formula (I): 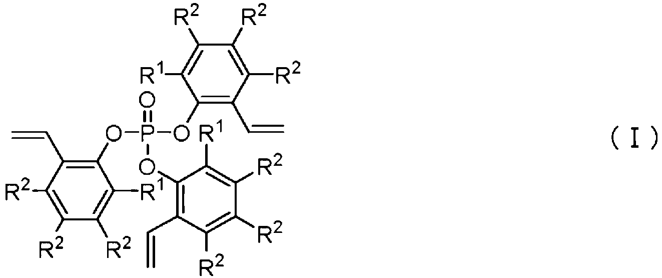 wherein each R¹ is the same or different and represents a hydrogen atom or a C₁₋₁₀ alkyl group, and each R² is the same or different and represents a hydrogen atom or a C₁₋₁₀ alkyl group.

A second invention relates to a resin composition comprising the flame retardant according to the first invention; and a resin component.

A third invention relates to a prepreg comprising the resin composition according to the second invention; and a base material.

A fourth invention relates to a metal foil with resin comprising a resin layer containing the resin composition according to the second invention or a semi-cured product of the resin composition; and metal foil.

A fifth invention relates to a thermosetting resin film formed from the resin composition according to the second invention.

A sixth invention relates to a metal-clad laminate comprising an insulation layer containing a cured product of the resin composition according to the second invention; and metal foil.

A seventh invention relates to a printed wiring board comprising an insulation layer containing a cured product of the resin composition according to the second invention or a cured product of the thermosetting resin film according to the fifth invention; and a wire.

An eighth invention relates to an adhesive containing the resin composition according to the second invention as a component.

### Advantageous Effects of Invention

The flame retardant of the present invention contains the phosphorus compound represented by chemical formula (I) and can be used as a flame retardant for various resins.

The phosphorus compound contained in the flame retardant of the present invention has a high phosphorus content in the molecule and has three o-vinylphenyl groups. Thus, when the phosphorus compound is used as a raw material for resin (resin material), the phosphorus compound is expected to provide a cured product excellent in flame retardancy, electrical characteristics **(e.g.,** low dielectric tangent), heat resistance, moisture absorption resistance, and hydrolysis resistance, as compared to when conventional flame retardants are used. Thus, the resin composition of the present invention can be suitably used as a material for printed wiring boards and the like.

Further, the adhesive of the present invention is expected to be excellent in adhesion, flame retardancy, electrical characteristics **(e.g.,** low dielectric tangent), heat resistance, moisture absorption resistance, hydrolysis resistance, and flame retardancy.

### Brief Description of Drawings

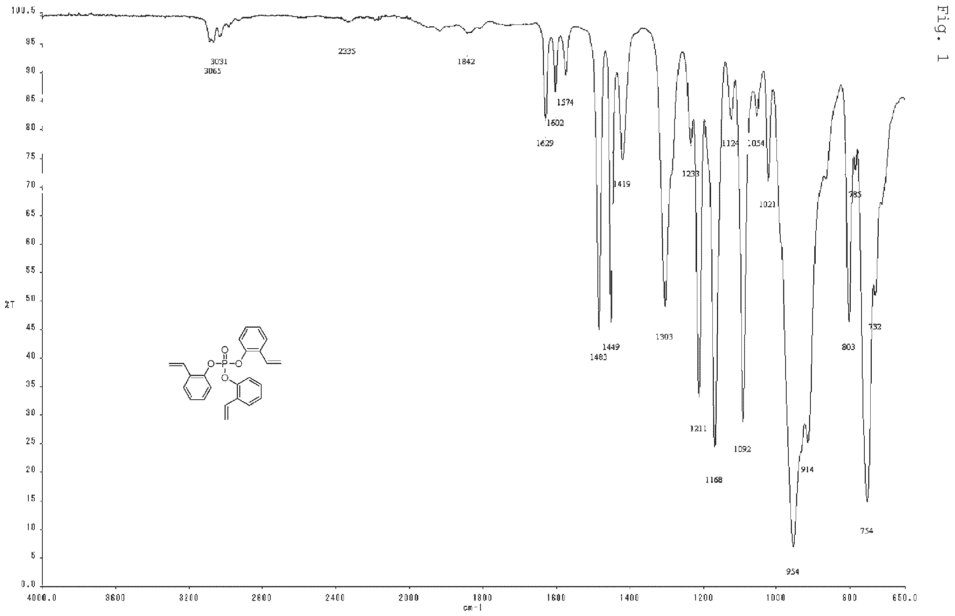

Fig. 1 is an IR spectrum chart of the pale-yellow liquid obtained in Synthesis Example **1.**

### Description of Embodiments

### 1. Phosphorus Compound

The flame retardant of the present invention contains a phosphorus compound represented by chemical formula (I).

Examples of the phosphorus compound represented by chemical formula (I) include phosphorus compounds represented by chemical formulas (I-1) to (I-18):

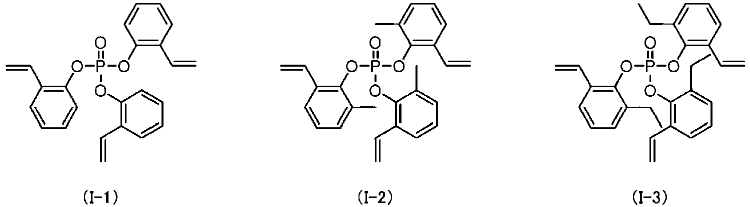

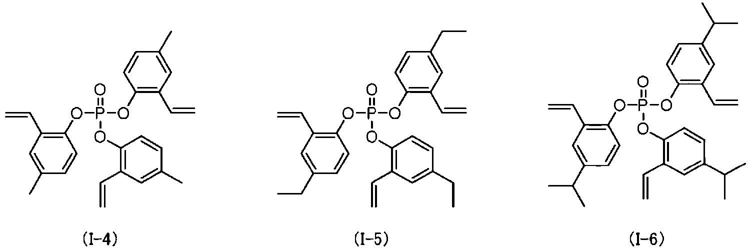

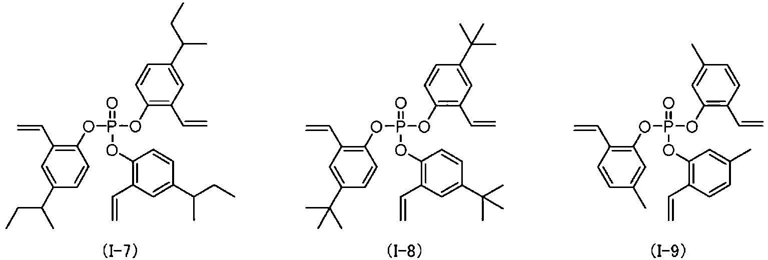

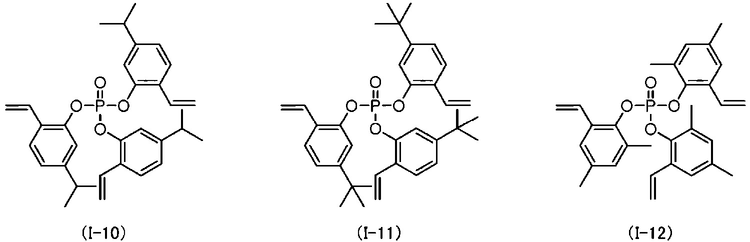

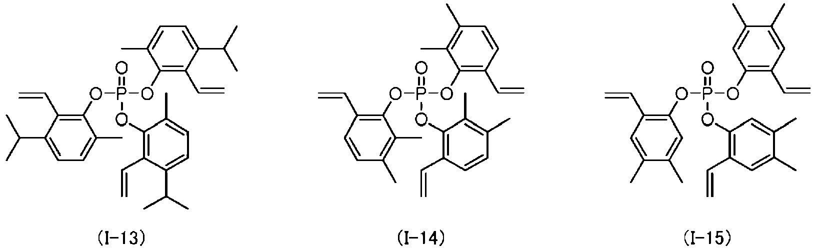

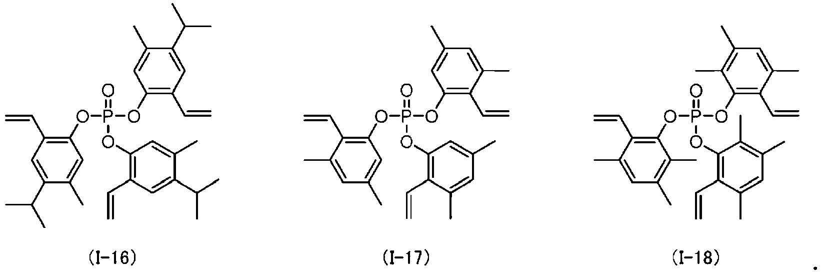

Other examples of the phosphorus compound represented by chemical formula (I) include tris(2-vinyl-6-isopropylphenyl)phosphate (I-19), tris(2-vinyl-6-s-butylphenyl)phosphate (I-20), tris(2-vinyl-6-t-butylphenyl)phosphate (I-21), tris(2-vinyl-4-methyl-6-t-butylphenyl)phosphate (I-22), tris(2-vinyl-4-t-butyl-6-t-butylphenyl)phosphate (I-23), tris(2-vinyl-3-methyl-6-isopropylphenyl)phosphate (I-24), and the like.

The C₁₋₁₀ alkyl group represented by R¹ and may be a linear or branched C₁₋₁₀ alkyl group. Specific examples include methyl, ethyl, n-propyl, isopropyl, n-butyl, s-butyl, isobutyl, t-butyl, n-pentyl, n-hexyl, heptyl, octyl, nonyl, decyl, and the like.

In the phosphorus compound represented by chemical formula (I), preferable substituents are as described below.

Preferably, each R¹ is the same and is hydrogen or C₁₋₅ alkyl. More preferably, each R¹ is hydrogen or C₁₋₄ alkyl.

Preferably, each is the same and is hydrogen or C₁₋₅ alkyl. More preferably, each is hydrogen.

### 2. Phosphorus Compound Synthesis Method

The phosphorus compound represented by chemical formula (I) can be synthesized by reacting an o-vinylphenol compound represented by chemical formula (II) with phosphoryl chloride represented by chemical formula (III) (see reaction scheme (A)): 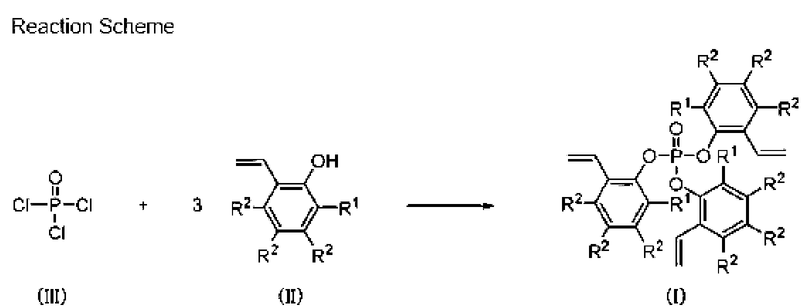 wherein R¹ and are as described above.

Examples of the o-vinylphenol compound represented by chemical formula (II) include o-vinylphenol compounds represented by chemical formulas (II-1) to (II-24):

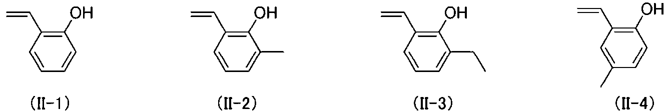

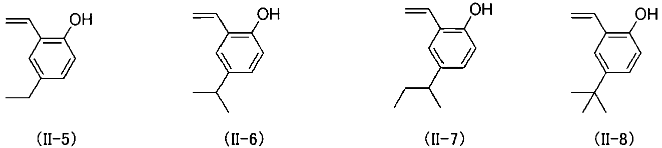

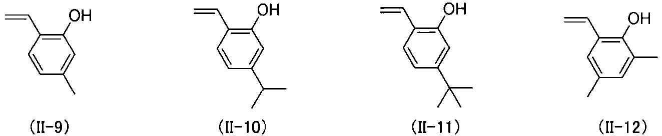

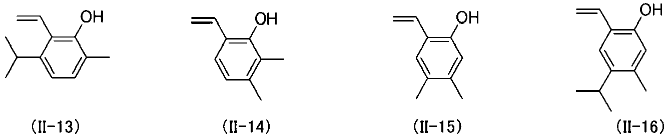

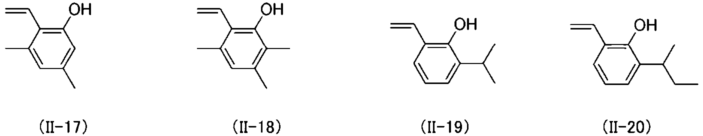

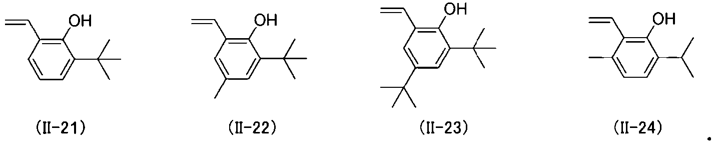

These o-vinylphenol compounds for use may be commercially available reagents purchased, or synthesized, for example, according to the methods described in Tetrahedron Letters (2005), 46(40), 6893-6896, Current Organic Synthesis (2019), 16(1), 130-135, Organic Letters (2012), 14(18), 4722-4725, Synthesis (2017), 49(23), 5217-5223, and the like.

The phosphoryl chloride for use may be a commercially available reagent purchased.

In this reaction, preferably, the amount of the **o-**vinylphenol compound used (the amount charged) is appropriately selected from the range of 3 to 6 times the molar amount of phosphoryl chloride used (the amount charged).

In performing this reaction, a base (a) may be used in order to accelerate the reaction. A reaction solvent (b) may be optionally used as needed.

Examples of the base (a) include trimethylamine, triethylamine, N,N-diisopropylethylamine, diazabicyclononene, diazabicycloundecene, pyridine, 4-dimethylaminopyridine, imidazole, sodium hydride, potassium hydride, lithium hydroxide, sodium hydroxide, potassium hydroxide, cesium hydroxide, lithium carbonate, sodium carbonate, potassium carbonate, cesium carbonate, lithium hydrogen carbonate, sodium hydrogen carbonate, potassium hydrogen carbonate, cesium hydrogen carbonate, trilithium phosphate, trisodium phosphate, tripotassium phosphate, tricesium phosphate, dilithium hydrogen phosphate, disodium hydrogen phosphate, dipotassium hydrogen phosphate, cesium dihydrogen phosphate, lithium dihydrogen phosphate, sodium dihydrogen phosphate, potassium dihydrogen phosphate, cesium dihydrogen phosphate, lithium acetate, sodium acetate, potassium acetate, cesium acetate, sodium alkoxide, potassium alkoxide, potassium t-butoxide, and the like. These may be used alone or in a combination of two or more.

Preferably, the amount of the base (a) used (the amount charged) is appropriately selected from the range of 0 to 40 times the molar amount of phosphoryl chloride used (the amount charged).

Any reaction solvent (b) may be used as long as it does not interfere with the reaction. Examples include solvents such as tetrahydrofuran, dioxane, ethyl acetate, acetonitrile, benzene, toluene, xylene, dichloromethane, chloroform, carbon tetrachloride, N,N-dimethylformamide, dimethylacetamide, dimethylsulfoxide, hexamethylphosphoric triamide, water, and the like. These can be combined as needed and used in an appropriate amount.

In this reaction, the reaction temperature is preferably set within the range of -10 to 150°C. The reaction time is set as appropriate according to the reaction temperature that has been set, but it is preferably set within the range of 1 to 100 hours.

After completion of the reaction, the phosphorus compound as the target product can be taken out from the resulting reaction solution (reaction mixture) by a means such as concentration of the reaction solution by distillation of reaction solvents, solvent extraction, crystallization, or the like.

Further, the phosphorus compound can be purified by a means such as washing with water etc., activated carbon treatment, silica gel chromatography, recrystallization, or the like as needed.

### 3. Resin Composition

The resin composition of the present invention may contain, in addition to the flame retardant of the present invention and a resin component, one or more other flame retardants, polymerizable components, polymerization initiators, reactive diluents, fluororesins, inorganic fillers, and additives as needed. In the present invention, the term "resin composition" refers to the mixture before curing.

### Resin Component

Any resin component (including resin before curing and semi-cured resin) may be used in the resin composition of the present invention as long as it is one generally used as a material of a resin molding material.

Examples of resin components include polyethylene resin, chlorinated polyethylene resin, polyvinyl chloride resin, polypropylene resin, polyisoprene resin, high-impact polystyrene resin, acrylonitrile-styrene resin (AS resin), acrylonitrile-butadiene-styrene resin (ABS resin), methylmethacrylate-butadiene-styrene resin (MBS resin), methylmethacrylate-acrylonitrile-butadiene-styrene resin (MABS resin), acrylonitrile-acrylic rubber-styrene resin (AAS resin), polymethyl (meth)acrylate resin, polyester resins (polyethylene terephthalate resin, polybutylene terephthalate resin, polyethylene naphthalate, etc.), unsaturated polyester resin, polyesterimide resin, polyketone resin, polycarbonate resin, polyamide resin, polyimide resin, polyamideimide resin, polycarbodiimide resin, polyetherimide resin, polyetherketone resin, polyetheretherketone resin (PEEK resin), polyethersulfone resin, polythioethersulfone resin, polysulfone resin, polyphenylene sulfide resin, polyethernitrile resin, polyarylate resin, polybenzimidazole resin, benzoxazine resin, liquid crystal polymer resin, silicone resin, epoxy resin, polyurethane resin, phenol resin, melamine resin, urea resin, diallyl phthalate resin, and the like. These may be used alone or in a combination of two or more.

The amount of the flame retardant of the present invention in the resin composition of the present invention is not limited. It is preferably 1 to 200 parts by weight, more preferably 1 to 160 parts by weight, and still more preferably 2 to 150 parts by weight, relative to 100 parts by weight of the resin component.

### Other Flame Retardant

The resin composition of the present invention may contain, as the flame retardant, one or more different flame retardants (other flame retardants) in addition to the flame retardant of the present invention, within the range in which the resin composition of the present invention can exhibit its effects.

Examples of other flame retardants include phosphate ester compounds, phosphazene compounds, phosphite ester compounds, phosphine compounds, melamine phosphate, phosphoric amide compounds, phosphoric amide ester compounds, phosphinate compounds and their salts, ammonium phosphate, ammonium polyphosphate, melam, melam polyphosphate, melem, melem polyphosphate, red phosphorus, melon, melamine, melamine pyrophosphate, melamine cyanurate, succinoguanamine, phosphonic acid esters, phosphinic acid esters, phosphine oxides, ethylenebispentabromobenzene, ethylenebistetrabromophthalimide, and the like.

Examples of phosphate ester compounds include triphenyl phosphate, tricresyl phosphate, xylenyl diphenyl phosphate, cresyl diphenyl phosphate, 1,3-phenylene bis(di-2,6-xylenyl phosphate), 9,10-dihydro-9-oxa-10-phosphaphenanthrene-10-oxide (DOPO), condensed phosphate ester compounds, such as aromatic condensed phosphate ester compounds, cyclic phosphate ester compounds, and the like.

Examples of phosphazene compounds include cyclic or linear phosphazene compounds. Cyclic phosphazene compounds, also known as cyclophosphazenes, are compounds having a ring structure with double bonds between phosphorus and nitrogen atoms in the molecule.

Examples of phosphite ester compounds include trimethyl phosphite, triethyl phosphite, and the like.

Examples of phosphine compounds include tris-(4-methoxyphenyl) phosphine, triphenylphosphine, and the like.

These may be used alone or in a combination of two or more.

The amount of other flame retardants in the resin composition of the present invention is not limited as long as it is within the range in which the resin composition of the present invention can exhibit its effects. The amount is 0 to 100 parts by weight, preferably 1 to 80 parts by weight, and more preferably 10 to 40 parts by weight, relative to 100 parts by weight of the resin component.

### Polymerizable Component

The resin composition of the present invention may contain a polymerizable component (polymerizable monomer and/or oligomer). Examples of polymerizable components include vinyl compounds, vinylidene compounds, diene compounds, acrylic compounds, cyclic compounds (epoxy compounds, lactone compounds, lactam compounds, cyclic ether compounds, etc.), and the like.

Examples of these polymerizable components include vinyl chloride, butadiene, isoprene, styrene, high-impact polystyrene precursor, acrylonitrile-styrene resin (AS resin) precursor, acrylonitrile-butadiene-styrene resin (ABS resin) precursor, methylmethacrylate-butadiene-styrene resin (MBS resin) precursor, methylmethacrylate-acrylonitrile-butadiene-styrene resin (MABS resin) precursor, acrylonitrile-acrylic rubber-styrene resin (AAS resin) precursor, methyl (meth)acrylate, epoxy acrylate resin precursor, epoxidized oil acrylate resin precursor, urethane acrylate resin precursor, polyester acrylate resin precursor, polyether acrylate resin precursor, acrylic acrylate resin precursor, unsaturated polyester resin precursor, vinyl/acrylate resin precursor, vinyl ether-based resin precursor, polyene/thiol resin precursor, silicone acrylate resin precursor, polybutadiene acrylate resin precursor, polystyryl(ethyl)methacrylate resin precursor, polycarbonate acrylate resin precursor, alicyclic epoxy resin precursor, glycidyl ether epoxy resin precursor, photocurable or thermal curable polyimide resin precursor, silicon-containing resin precursor, epoxy resin precursor, and the like. These may be used alone or in a combination of two or more. The term "precursor" refers to a monomer or an oligomer.

The amount of the polymerizable component in the resin composition of the present invention is not limited. It is 0 to 200 parts by weight, preferably 0.5 to 100 parts by weight, and more preferably 1 to 50 parts by weight, relative to 100 parts by weight of the resin component.

### Polymerization Initiator

The resin composition of the present invention may contain a polymerization initiator. The polymerization initiator can be appropriately selected according to the polymerization method of the resin composition of the present invention. Examples of polymerization initiators include thermal polymerization initiators, photopolymerization initiators, radical polymerization initiators, and the like.

Examples of thermal polymerization initiators include azo compounds, such as 2,2-azobisisobutyronitrile (AIBN), **2,2-**azobis(2-methylbutyronitrile), azobis-2,4-dimethylvaleronitrile, azobis cyclohexyl nitrile, and azobis cyanovaleric acid; peroxides, such as benzoyl peroxide, dicumyl peroxide, and diisopropyl peroxydicarbonate; acid generators, such as aromatic sulfonates; and the like. These may be used alone or in a combination of two or more.

Examples of photopolymerization initiators include acetophenone-based photopolymerization initiators, benzophenone-based photopolymerization initiators, benzoin-based photopolymerization initiators, thioxanthone-based photopolymerization initiators, sulfonium-based photopolymerization initiators, iodonium-based photopolymerization initiators, and the like. These may be used alone or in a combination of two or more.

When one or more photopolymerization initiators are used, a sensitizer, such as a tertiary amine, may be used in combination with these photopolymerization initiators as needed.

Examples of radical polymerization initiators include peroxides, such as di-t-butyl peroxide, 2,5-dimethyl-2,5-di(t-butylperoxide)hexane, 2,5-dimethyl-2,5-di(t-butylperoxide)hexyne-3, α,α'-di(t-butylperoxy)diisopropylbenzene, and t-butyl peroxybenzoate. These may be used alone or in a combination of two or more.

The amount of the polymerization initiator in the resin composition of the present invention is not limited. It is 0.001 to 10 parts by weight, preferably 0.01 to 8 parts by weight, and more preferably 0.1 to 5 parts by weight, relative to 100 parts by weight of the resin component.

### Reactive Diluent

The resin composition of the present invention may contain a reactive diluent as needed.

Examples of reactive diluents include aliphatic alkyl glycidyl ethers, such as butyl glycidyl ether, 2-ethylhexyl glycidyl ether, and allyl glycidyl ether; alkyl glycidyl esters, such as glycidyl methacrylate and glycidyl esters of tertiary carboxylic acids; and aromatic alkyl glycidyl ethers, such as styrene oxide, phenyl glycidyl ether, cresyl glycidyl ether, p-s-butylphenyl glycidyl ether, and nonylphenyl glycidyl ether. These may be used alone or in a combination of two or more.

The amount of the reactive diluent in the resin composition of the present invention is not limited. It is 0 to 100 parts by weight, preferably 0.1 to 50 parts by weight, and more preferably 0.1 to 20 parts by weight, relative to 100 parts by weight of the resin component.

### Fluororesin

The resin composition of the present invention may contain a fluororesin in order to improve the flame retardancy (particularly, drip prevention performance) of a cured product (formed body) of the resin composition.

Examples of fluororesins include polytetrafluoroethylene (PTFE), tetrafluoroethylene-hexafluoropropylene copolymer (FEP), tetrafluoroethylene-perfluoroalkyl vinyl ether copolymer (PFA), tetrafluoroethylene-ethylene copolymer (ETFE), poly(trifluorochloroethylene) (CTFE), polyvinylidene fluoride (PVdF), and the like. These may be used alone or in a combination of two or more.

The amount of the fluororesin in the resin composition of the present invention is not limited. It is 0 to 20 parts by weight, preferably 0.1 to 10 parts by weight, relative to 100 parts by weight of the resin component.

### Inorganic Filler

The resin composition of the present invention may contain an inorganic filler in order to improve the flame retardancy (in particular, drip prevention performance) and mechanical strength of a cured product (formed body) of the resin composition.

Examples of inorganic fillers include mica, natural mica, synthetic mica, kaolin, calcined kaolin, talc, calcined talc, wollastonite, silica, alumina, boron nitride, clay, calcined clay, titania, barium sulfate, barium carbonate, calcium carbonate, calcium sulfate, aluminum hydroxide, magnesium hydroxide, calcium silicate, titanium oxide, zinc oxide, zinc borate, glass beads, glass balloons, glass flakes, short glass fibers, fine glass powder, hollow glass, fibrous alkali metal titanates (potassium titanate fibers, sodium titanate fibers, etc.), fibrous borates (aluminum borate fibers, magnesium borate fibers, zinc borate fibers, etc.), zinc oxide fibers, titanium oxide fibers, magnesium oxide fibers, gypsum fibers, aluminum silicate fibers, calcium silicate fibers, silicon carbide fibers, titanium carbide fibers, silicon nitride fibers, titanium nitride fibers, carbon fibers, alumina fibers, alumina-silica fibers, zirconia fibers, quartz fibers, flaky titanates, flaky titanium dioxide, and the like. These may be used alone or in a combination of two or more.

In particular, in order to reduce the dielectric constant of the resin composition, a low-dielectric constant filler, such as silica or boron nitride, is preferably used as an inorganic filler. Examples of silica include ground silica, fused silica, natural silica, calcined silica, synthetic silica, crystalline silica, amorphous silica, and the like.

Preferably, the average particle size of the inorganic filler is 5 µm or less. For example, the use of an inorganic filler, such as silica particles, having an average particle size of 5 µm or less enhances adhesion to metallic foil when the resin composition is used in a metal-clad laminate etc.

The surface of the inorganic filler may be covered with a silane coupling agent in order to prevent or reduce deterioration of the resin component.

The amount of the inorganic filler in the resin composition of the present invention is not limited. In terms of balance between improvement in flame retardancy and improvement in mechanical characteristics, the amount of the inorganic filler is 0 to 800 parts by weight, preferably 1 to 600 parts by weight, and more preferably 10 to 400 parts by weight, relative to 100 parts by weight of the resin component.

### Additive

The resin composition of the present invention may contain various additives depending on the application, type of the resin component, etc., within the range that does not impair the desired physical properties.

Examples of additives include white carbon, aluminum nitride, zinc borate, zinc stannate, zinc molybdate, molybdenum oxide, silicon nitride, Aerosil, wollastonite, nanocarbons (nanocarbon tubes, graphene, fullerenes, etc.), organic fibers (aramid fiber, polyparaphenylene benzbisoxazole fiber, etc.), silane coupling agents, waxes, fatty acids and their metal salts, release agents (acid amides, paraffin, etc.), chlorinated paraffins, silicone-based flame retardant, bromine-based flame retardant, flame-retardant aids (antimony trioxide etc.), UV absorbers (benzophenone compounds, benzotriazole compounds, cyanoacrylate compounds, triazine compounds, etc.), antioxidants (hindered phenol compounds, styrenated phenol compounds, organophosphorus-based peroxide decomposers, organic sulfur-based peroxide decomposers, etc.), fluorescent whitening agents (stilbene derivatives etc.), light stabilizers (hindered amine compounds etc.), photosensitizers, gloss agents, metal deactivators (benzotriazole compounds etc.), light-blocking agents (rutile titanium oxide, zinc oxide, chromium oxide, cerium oxide, etc.), quenchers (organic nickel etc.), curing agents, curing accelerators, crosslinking agents, diluents, flow adjusters, polymerization inhibitors, dyes, pigments, colorants, anti-fogging agents, anti-fungal agents, antibacterial agents, deodorants, plasticizers, antistatic agents, surfactants, defoamers, foaming agents, leveling agents, slip agents, lubricants, thixotropic agents, thickeners, nucleating agents, reinforcing agents, compatibilizers, conductive agents, antiblocking agents, anti-tracking agents, phosphorescent agents, plasticizers, adhesives, glues, tackifiers, various stabilizers, and the like. These may be used alone or in a combination of two or more.

The amount of additives in the resin composition of the present invention is not limited. It is 0 to 50 parts by weight, preferably 1 to 20 parts by weight, relative to 100 parts by weight of the resin component.

The resin composition of the present invention can be produced by mixing and/or kneading a resin component and the flame retardant of the present invention as well as other flame retardants, polymerizable components, polymerization initiators, reactive diluents, fluororesins, inorganic fillers, and additives, by a publicly known method. For example, the resin composition can be produced by mixing and/or kneading a mixture of the components in liquid, powder, bead, flake, or pellet form, using an extruder (a single-crew extruder, a twin-screw extruder, etc.), a kneader (a Banbury mixer, a pressure kneader, a two-roll mill, a three-roll mill, etc.), or the like.

### 4. Thermal Radical Curable Resin Composition

The resin composition of the present invention (referred to below as "the thermal radical curable resin composition of the present invention") contains the flame retardant of the present invention and a thermal radical curable resin component. The thermal radical curable resin composition of the present invention may also contain, in addition to the flame retardant of the present invention and a thermal radical curable resin component, other resin components, other flame retardants, crosslinking agents, radical polymerization initiators, inorganic fillers, stress relief agents, organic solvents, and additives, as needed. In the present invention, the term "resin composition" refers to the mixture before curing.

### Thermal Radical Curable Resin Component

Examples of thermal radical curable resin components (including resin before curing and semi-cured resin) for use in the thermal radical curable resin composition of the present invention include polyphenylene ether resins, bismaleimide resins, bismaleimide-triazine resins, polyfunctional styrene compounds, polystyrene resins, polybutadiene resins, benzocyclobutene resins, polytetrafluoroethylene resins, acrylic resins, and the like.

Examples of polyphenylene ether resins include a compound having a structure represented by formula (1): 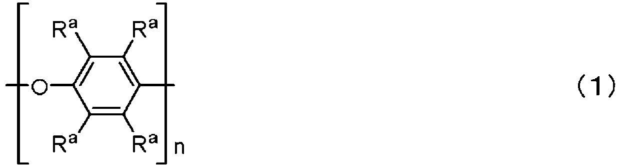 wherein each R^{a} is the same or different and represents hydrogen, C₁₋₆ alkyl, or C₂₋₆ alkenyl, and n represents the number of repeating units and is usually an integer of 1 or greater.

The C₁₋₆ alkyl group represented by R^{a} may be a linear or branched C₁₋₆ alkyl group. Specific examples include methyl, ethyl, n-propyl, isopropyl, n-butyl, t-butyl, n-pentyl, n-hexyl, and the like. Of these, methyl is preferable.

The C₂₋₆ alkenyl group represented by R^{a} may be a linear or branched C₂₋₆ alkenyl group. Specific examples include vinyl, allyl, isopropenyl, 1-butenyl, 2-butenyl, 3-butenyl, pentenyl, hexenyl, and the like.

Preferably, each R^{a} is the same or different and represents hydrogen or methyl.

Preferably, n is 1 to 400.

Examples of an embodiment of the compound having a structure represented by formula (1) include a compound having a structure represented by formula (1-1), a compound having a structure represented by formula (1-2), and a compound having a structure represented by formula (1-3): 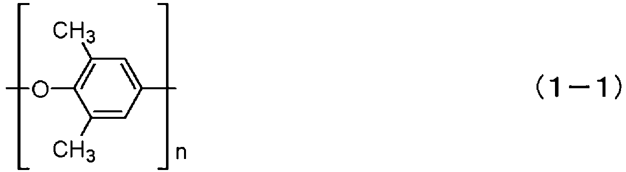
wherein n is as described above, 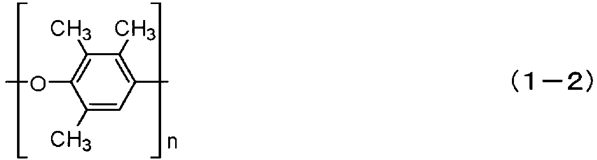
wherein n is as described above, 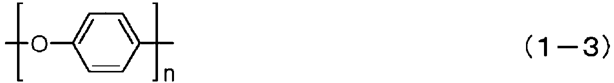
wherein n is as described above.

The compound having a structure represented by formula (1) preferably has two or more structures represented by formula (1) in the molecule. Further, the compound preferably has a crosslinkable group (e.g., a group having a carbon-carbon double bond, such as (meth)acryl, allyl, or vinylbenzyl). The crosslinkable group is preferably present at one or both terminals of the molecule of the compound.

A preferred embodiment of the compound having a structure represented by formula (1) is, for example, a compound represented by chemical formula (IV): 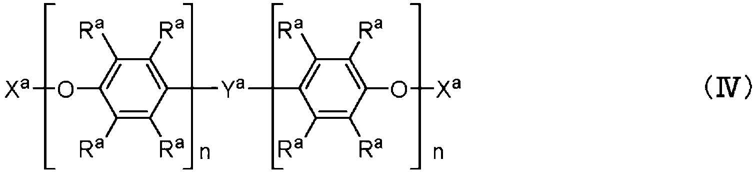
wherein each X^{a} is the same or different and represents hydrogen or a group represented by formula (2), Y^{a} represents -O- or a group represented by formula (3), R^{a} is as described above, and each n is the same or different and is as described above: 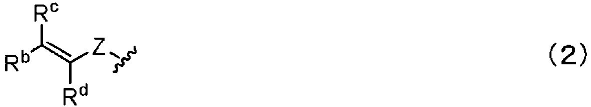
wherein R^{b}, R^{c}, and R^{d} are the same or different and each represents hydrogen or C₁₋₃ alkyl, and each Z is the same or different and represents C₁₋₁₀ alkylene, -C(=O)-, -Ph-, -Ph-CH₂-, or -Ph-CH₂CH₂-, 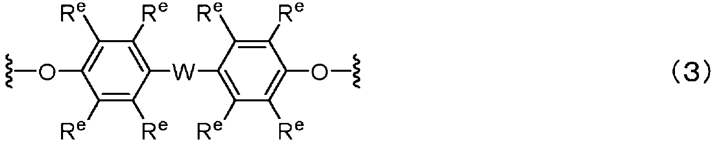
wherein each R^{e} is the same or different and represents hydrogen, C₁₋₆ alkyl, C₂₋₆ alkenyl, or aryl, and W represents a single bond, C₁₋₆ alkylene optionally substituted with phenyl, cycloalkylene, C₂₋₆ alkenediyl optionally substituted with halogen, -C(=O)-, - S(O)ₘ- (wherein m represents 0, 1, or 2), or -(alkylene)-(phenylene)-(alkylene)-.

Examples of the C₁₋₃ alkyl group represented by R^{b}, R^{c}, and R^{d} include methyl, ethyl, n-propyl, isopropyl, and the like. Preferably, R^{b} and R^{c} are hydrogen. Preferably, R^{d} is hydrogen or methyl.

Examples of the C₁₋₁₀ alkylene represented by Z include methylene, methylmethylene, dimethylene, trimethylene, ethylmethylene, dimethylmethylene, tetramethylene, pentamethylene, hexamethylene, heptamethylene, octamethylene, nonamethylene, decamethylene, and the like.

Z is preferably -C(=O)-, -Ph-, -Ph-CH₂-, or -Ph-CH₂CH₂-.

The C₁₋₆ alkyl group represented by R^{e} may be a linear or branched C₁₋₆ alkyl group. Specific examples include methyl, ethyl, n-propyl, isopropyl, n-butyl, t-butyl, n-pentyl, n-hexyl, and the like.

The C₂₋₆ alkenyl group represented by R^{e} may be a linear or branched C₂₋₆ alkenyl group. Specific examples include vinyl, allyl, isopropenyl, 1-butenyl, 2-butenyl, 3-butenyl, pentenyl, hexenyl, and the like.

Examples of the aryl group represented by R^{e} include phenyl, 2-tolyl, 3-tolyl, 4-tolyl, and the like.

Preferably, R^{e} is hydrogen or methyl.

Examples of the C₁₋₆ alkylene group optionally substituted with phenyl represented by W include methylene, methylmethylene, dimethylmethylene, phenylmethylene, phenylmethylmethylene, diphenylmethylene, and the like.

Examples of the cycloalkylene group represented by W include cyclohexane-1,1-diyl and the like.

Examples of the C₂₋₆ alkenediyl group optionally substituted with halogen represented by W include ethylene-1,1-diyl, 2,2-dichloroethylene-1,1-diyl, and the like.

Examples of -(alkylene)-(phenylene)-(alkylene)-represented by W include -(C₁₋₃ alkylene) - (phenylene) - (C₁₋₃ alkylene)- and the like. The C₁₋₃ alkylene group may be methylene, methylmethylene, dimethylene, trimethylene, ethylmethylene, dimethylmethylene, or the like, preferably dimethylmethylene. The phenylene group may be 1,2-phenylene, 1,3-phenylene, or 1,4-phenylene, preferably 1,4-phenylene.

W is preferably C₁₋₆ alkylene, and more preferably C₁₋₃ alkylene (particularly, dimethylmethylene).

Y^{a} is preferably a group represented by formula (3) (wherein R^{e} represents hydrogen or methyl, and W represents C₁₋₃ alkylene).

Preferred examples of the compound represented by chemical formula (IV) include a compound represented by chemical formula (IV-1), a compound represented by chemical formula (IV-2), and a compound represented by chemical formula (IV-3): 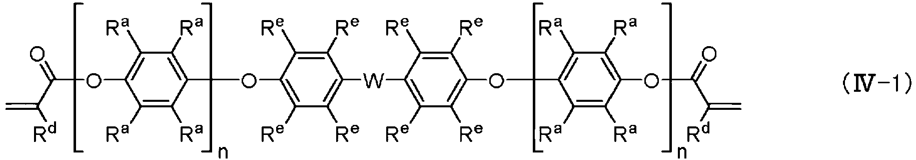
wherein R^{a}, R^{d}, R^{e}, W, and n are as described above, 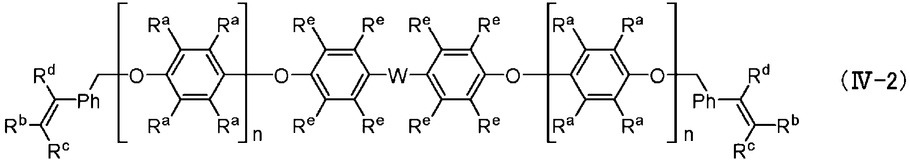
wherein R^{a}, R^{b}, R^{c}, R^{d}, R^{e}, W, and n are as described above, and 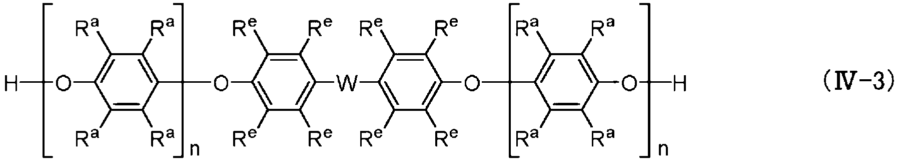
wherein R^{a}, R^{e}, W, and n are as described above.

These polyphenylene ether resins can be synthesized by or based on a publicly known method described in, for example, US Patent No. 4059568 or the Journal of Organic Chemistry (1969), 34, 297-303.

Commercially available polyphenylene ether resins can also be used. Examples of commercial products include SA9000-111 (product name) available from SABIC; OPE-2St (product name) and OPE-2EA (product name) available from Mitsubishi Gas Chemical Company, Inc.; and the like.

These polyphenylene ether resins may be used alone or in a combination of two or more.

The weight average molecular weight (Mw) of polyphenylene ether resins is generally 1000 to 120000, preferably 1000 to 50000, more preferably 1000 to 20000. The weight average molecular weight can be measured by using gel permeation chromatography (GPC) using styrene standards.

Bismaleimide resins are compounds having two maleimide groups in the molecule and refer to bismaleimide compounds before curing. Examples of bismaleimide resins include aliphatic bismaleimide compounds, aromatic bismaleimide compounds, and the like.

Examples of aliphatic bismaleimide compounds include N,N'-(2,2,4-trimethylhexamethylene)bismaleimide, N,N'-decamethylenebismaleimide, N,N'-octamethylenebismaleimide, N,N'-heptamethylenebismaleimide, N,N'-hexamethylenebismaleimide, N,N'-pentamethylenebismaleimide, N,N'-tetramethylenebismaleimide, N,N'-trimethylenebismaleimide, N,N'-ethylenebismaleimide, N,N'-(oxydimethylene)bismaleimide, 1,13-bismaleimido-4,7,10-trioxatridecane, 1,11-bismaleimido-3,6,9-trioxaundecane, and the like.

Examples of aromatic bismaleimide compounds include N,N'-(4-methyl-1,3-phenylene)bismaleimide, N,N'-(1,3-phenylene)bismaleimide, N,N'-(1,4-phenylene)bismaleimide, N,N'-(1,2-phenylene)bismaleimide, N,N'-(1,5-naphthylene)bismaleimide, N,N'-(4-chloro-1,3-phenylene)bismaleimide, N,N'-(methylenedi-p-phenylene)bismaleimide, N,N'-(4,4'-biphenylene)bismaleimide, N,N'-(sulfonyldi-p-phenylene)bismaleimide, N,N'-(oxydi-p-phenylene)bismaleimide, N,N'-(3,3'-dimethyl-4,4'-biphenylene)bismaleimide, N,N'-(benzylidenedi-p-phenylene)bismaleimide, N,N'-[methylenebis(3-chloro-4-phenylene)]bismaleimide, N,N'-[methylenebis(3-methyl-4-phenylene)]bismaleimide, N,N'-[methylenebis(3-methoxy-4-phenylene)]bismaleimide, N,N'-(thiodi-p-phenylene)bismaleimide, N,N'-3,3'-benzophenonebismaleimide, N,N'-[methylenebis(3-methyl-5-ethyl-4-phenylene)]bismaleimide, N,N'-[tetramethylenebis(oxy-p-phenylene)]bismaleimide, 2,2-bis[4-(4-maleimidophenoxy)phenyl]propane, bis[4-(4-maleimidophenoxy)phenyl)sulfone, 1,4-phenylenebis(4-maleimidophenoxy), bis[3-(4-maleimidophenoxy)phenyl]sulfone, bis[4-(3-maleimidophenoxy)phenyl]ketone, 1,3-phenylenebis(4-maleimidophenoxy), bis[4-(4-maleimidophenylthio)phenyl]ether, and the like.

A commercially available bismaleimide resin can also be used. Examples of commercial products include BMI-689 (product name), BMI-1500 (product name), BMI-2500 (product name), and BMI-3000J (product name) available from Designer Molecules Inc.; BMI-1000 (product name), BMI-2300 (product name), BMI-4000 (product name), BMI-5100 (product name) available from Daiwa Kasei Industry Co. Ltd.; MIR-3000-70MT (product name) and MIR-5000 (product name) available from Nippon Kayaku Co., Ltd.; BMI (product name), BMI-70 (product name), and BMI-80 (product name) available from KI Chemical Industry Co., Ltd.; and the like.

These bismaleimide resins may be used alone or in a combination of two or more.

Any bismaleimide-triazine resin may be used as long as it is obtained by prepolymerizing a maleimide compound and a cyanic acid ester compound as main components. Examples include a resin obtained by melting 2,2-bis(4-cyanatophenyl)propane and bis(3-ethyl-5-methyl-4-maleimidophenyl)methane by heating, and polymerizing them; and a resin obtained by melting a novolac cyanic acid ester resin and bis(3-ethyl-5-methyl-4-maleimidophenyl)methane by heating, and polymerizing them, followed by dissolving in methyl ethyl ketone.

Examples of polyfunctional styrene compounds include bisvinylphenylmethane, 1,2-bis(m-vinylphenyl)ethane, 1,2-bis(p-vinylphenyl)ethane, 1-(p-vinylphenyl)-2-(m-vinylphenyl)ethane, 1,3-bis(m-vinylphenylethyl)benzene, 1,3-bis(p-vinylphenylethyl)benzene, 1-(p-vinylphenylethyl)-3-(m-vinylphenylethyl)benzene, 1,4-bis(m-vinylphenylethyl)benzene, 1,4-bis(p-vinylphenylethyl)benzene, 1,6-bis(vinylphenyl)hexane, compounds represented by chemical formula (VII), and divinylbenzene polymers (oligomers) with vinyl in the side chains: 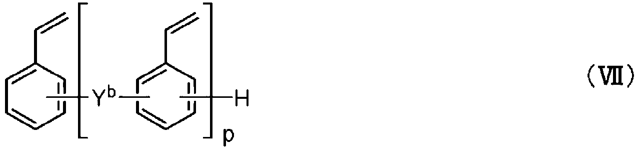 wherein each Y^{b} is the same or different and represents -(C₁₋₃ alkylene)-(a divalent organic group having a ring structure)-(C₁₋₃ alkylene)-, and p represents an integer from 1 to 10.

Examples of C₁₋₃ alkylene include methylene, methylmethylene, dimethylene, trimethylene, ethylmethylene, dimethylmethylene, and the like.

Examples of the divalent organic group having a ring structure include phenylene, xylylene, naphthylene, tolylene, biphenylene, a group containing an indane structure, a group containing a cycloolefin structure, and the like.

Preferred examples of the compound represented by chemical formula (VII) include a compound represented by chemical formula (VII-1), a compound represented by chemical formula (VII-2), and the like: 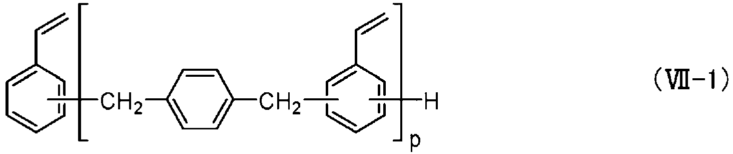
wherein p represents an integer from 1 to 10, 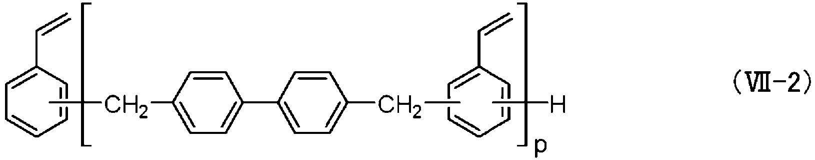
wherein p represents an integer from 1 to 10.

Examples of polystyrene resins include a compound having a structure represented by formula (4): 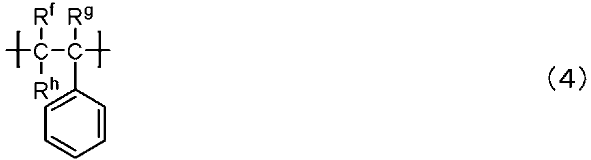 wherein R^{f}, R^{g}, and R^{h} are the same or different and each represents hydrogen or C₁₋₆ alkyl.

The C₁₋₆ alkyl group represented by R^{f}, R^{g}, and R^{h} may be a linear or branched C₁₋₆ alkyl group. Specific examples include methyl, ethyl, n-propyl, isopropyl, n-butyl, t-butyl, n-pentyl, n-hexyl, and the like.

Examples of an embodiment of the compound having a structure represented by formula (4) include a compound having a structure represented by formula (4-1) and a compound having a structure represented by formula (4-2):

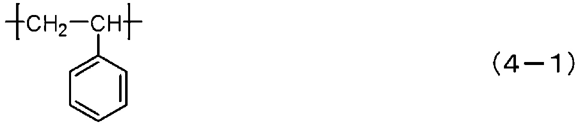

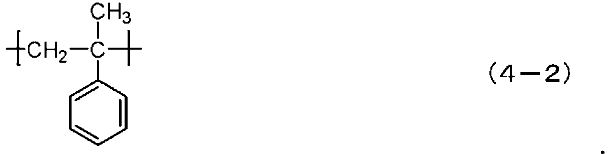

Preferably, the compound having a structure represented by formula (4) has a structure represented by formula (5) in the molecule. This compound may be a polymer in which the structure represented by formula (4) and the structure represented by formula (5) are randomly bonded, or this compound may be a block copolymer or a random copolymer: 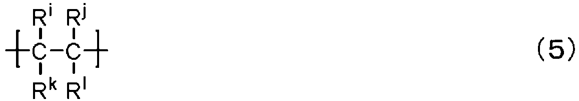 wherein Rⁱ, R^{j}, and R^{k} are the same or different and each represents hydrogen or C₁₋₆ alkyl, and R^{l} represents aryl.

The C₁₋₆ alkyl group represented by Rⁱ, R^{j}, and R^{k} may be a linear or branched C₁₋₆ alkyl group. Specific examples include methyl, ethyl, n-propyl, isopropyl, n-butyl, t-butyl, n-pentyl, n-hexyl, and the like.

The aryl group represented by R^{l} may be an aryl group unsubstituted or substituted with alkyl or the like. Specific examples include methylphenyl, ethylphenyl, propylphenyl, butylphenyl, t-butylphenyl, vinylphenyl, naphthyl, ethylnaphthyl, biphenylyl, ethylbiphenylyl, and the like.

Examples of an embodiment of the structure represented by formula (5) include a structure represented by formula (5-1), a structure represented by formula (5-2), and a structure represented by formula (5-3):

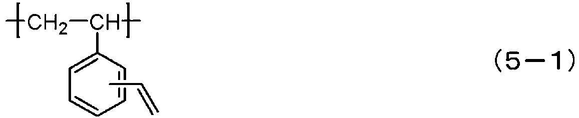

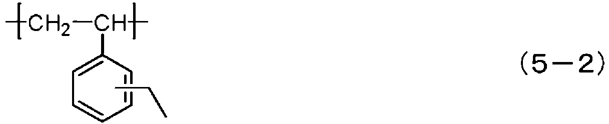

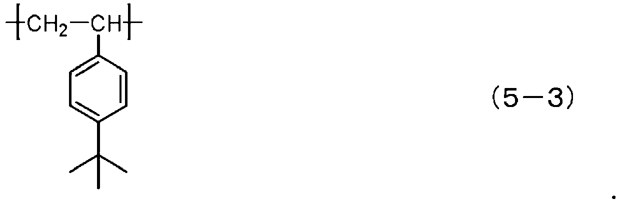

The compound having a structure represented by formula (4) has a structure represented by formula (6) in the molecule. This compound may be a polymer in which the structure represented by formula (4) and the structure represented by formula (6) are randomly bonded, or this compound may be a block copolymer or a random copolymer. Alternatively, this compound may be a polymer in which the structure represented by formula (4), the structure represented by formula (5), and the structure represented by formula (6) are randomly bonded, or this compound may be a block copolymer or a random copolymer: 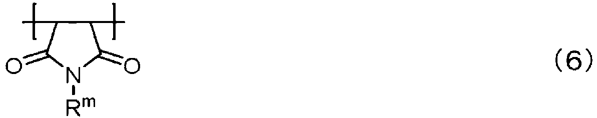 wherein R^{m} represents hydrogen, C₁₋₁₈ alkyl, C₅₋₈ cycloalkyl, aryl, or benzyl.

The C₁₋₁₈ alkyl group represented by R^{m} may be a linear or branched C₁₋₁₈ alkyl group. Specific examples include methyl, ethyl, n-propyl, isopropyl, n-butyl, isobutyl, t-butyl, n-pentyl, n-hexyl, heptyl, octyl, nonyl, decyl, undecyl, dodecyl, tridecyl, tetradecyl, pentadecyl, hexadecyl, heptadecyl, octadecyl, and the like.

Examples of the C₅₋₈ cycloalkyl group represented by R^{m} include cyclopentyl, cyclohexyl, cycloheptyl, cyclooctyl, and the like.

The aryl group represented by R^{m} may be an unsubstituted or substituted aryl group. Specific examples include phenyl, 4-hydroxyphenyl, 4-acetylphenyl, 4-methoxyphenyl, 4-ethoxyphenyl, 4-chlorophenyl, 4-bromophenyl, and the like.

A preferred embodiment of the compound having a structure represented by formula (4) may be a compound having, in the molecule, a structural unit represented by formula (4-1) and also at least one of a structural unit represented by formula **(5-**1) and a structural unit represented by formula (5-2). This compound may be a block copolymer or a random copolymer.

Preferably, the molar content of the structural unit represented by formula (4-1) is 1 to 92 mol%, the molar content of the structural unit represented by formula (5-1) is 0 to 54 mol%, and the molar content of the structural unit represented by formula (5-2) is 0 to 89 mol%.

The average number of structural units represented by formula (4-1) is preferably 1 to 350. The average number of structural units represented by formula (5-1) is preferably 0 to 160. The average number of structural units represented by formula (5-2) is preferably 0 to 270.

Commercially available polystyrene resins can also be used. Examples of commercial products include ODV-XET (X03) (product name), ODV-XET (X04) (product name), ODV-XET (X05) (product name), and the like available from NIPPON STEEL Chemical & Material Co., Ltd.

These polystyrene resins may be used alone or in a combination of two or more.

The weight average molecular weight (Mw) of polystyrene resins is preferably 1500 to 40000, and more preferably 1500 to 35000. The weight average molecular weight can be measured by using gel permeation chromatography (GPC) using styrene standards.

Examples of polybutadiene resins include a compound having at least one of the following: the polybutadiene structure represented by formula (7), the polybutadiene structure represented by formula (8), and the polybutadiene structure represented by formula (9). These polybutadiene structures include not only structures formed by polymerizing butadiene but also structures formed by hydrogenating a polybutadiene structure. In this compound, the at least one polybutadiene structure may be present in the main chain or the side chain: 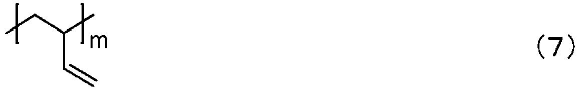
wherein m represents the number of repeating units and is usually an integer of 1 or greater, 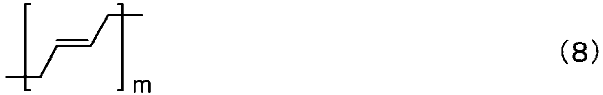
wherein m represents the number of repeating units and is usually an integer of 1 or greater, and 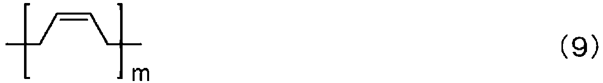
wherein m represents the number of repeating units and is usually an integer of 1 or greater.

The compound having at least one of the polybutadiene structure represented by formula (7), the polybutadiene structure represented by formula (8), and the polybutadiene structure represented by formula (9) may contain the structure represented by formula (6) in the molecule. This compound may be a polymer in which at least one polybutadiene structure of the polybutadiene structure represented by formula (7), the polybutadiene structure represented by formula (8), and the polybutadiene structure represented by formula (9) is randomly bonded to the structure represented by formula (6), or this compound may be a block copolymer or a random copolymer.

Other examples of polybutadiene resins include butadiene homopolymers, epoxy-modified polybutadiene, butadiene-styrene-random copolymers, maleic acid-modified polybutadiene, and the like.

Commercially available polybutadiene resins can also be used. Examples of commercial products include Ricon 130 (product name), Ricon 131 (product name), Ricon 142 (product name), Ricon 150 (product name), Ricon 152 (product name), Ricon 153 (product name), Ricon 156 (product name), and Ricon 157 (product name) available from Cray Valley; B-1000 (product name), B-2000 (product name), and B-3000 (product name)-available from Nippon Soda **Co.,** Ltd. (butadiene homopolymers); Ricon 100 (product name) and Ricon 181 (product name) available from Cray Valley (butadiene-styrene-random copolymers); Ricon 130MA8 (product name), Ricon 130MA13 (product name), Ricon 130MA20 (product name), and Ricon 156MA17 (product name) available from Cray Valley (maleic acid-modified polybutadiene); and the like.

These polybutadiene resins may be used alone or in a combination of two or more.

The number average molecular weight (Mn) of polybutadiene resins is preferably 500 to 10000, more preferably 1000 to 6000. The number average molecular weight can be measured by using gel permeation chromatography (GPC) using styrene standards.

Any benzocyclobutene resin may be used as long as two or more benzocyclobutene groups are bonded directly or via an organic group.

In the thermal radical curable resin composition of the present invention, the thermal radical curable resin components described above may be used alone or in a combination of two or more.

### Other Resin Component

The thermal radical curable resin composition of the present invention may contain, in addition to a thermal radical curable resin component, one or more resin components other than the thermal radical curable resin component (other resin components), as necessary. Examples of such other resin components include the resin components described above and styrene-based block copolymers.

Examples of styrene-based block copolymers include styrene-butadiene block copolymers, styrene-butadiene-styrene block copolymers (SBS), styrene-isoprene block copolymers, styrene-ethylene/butylene-styrene block copolymers (SEBS), styrene-(ethylene-ethylene/propylene)-styrene block copolymers (SEEPS), and styrene-ethylene/propylene-styrene block copolymers (SEPS). These copolymers can be used singly or in a combination of two or more.

Usable styrene-based block copolymers can be commercially available products. Examples of commercially available products include Tufprene (product name), Asaprene T (product name), and Tuftec (product name) all available from Asahi Kasei Corporation, Elastomer AR (product name) available from Aronkasei Co., Ltd., Kraton G (product name) and Califlex (product name) both available from Kraton Polymer Japan, JSR-TR (product name), TSR-SIS (product name), and Dynaron (product name) all available from JSR, Denka STR (product name) available from Denka Company Limited, Quintac (product name) available from Zeon Corporation, Esporex SB Series (product name) available from Sumitomo Chemical Co., Ltd., Septon (product name) and Hybra (product name) available from Kuraray Co., Ltd., Sumiflex (product name) available from Sumitomo Bakelite Co., Ltd., and Leostomer (product name) and Actimer (product name) available from Riken Technos Corporation. These styrene-based block copolymers may be used singly or in a combination of two or more.

The amount of other resin components in the thermal radical curable resin composition of the present invention is not limited. It is 0 to 1000 parts by weight, preferably 1 to 800 parts by weight, and more preferably 10 to 700 parts by weight, relative to 100 parts by weight of the thermal radical curable resin component.

### Flame Retardant

The thermal radical curable resin composition of the present invention may contain, in addition to the flame retardant of the present invention, one or more other flame retardants described in the section "3. Resin Composition" above, as necessary.

The amount of the flame retardant of the present invention in the thermal radical curable resin composition of the present invention is not limited. It is 1 to 200 parts by weight, preferably 1 to 160 parts by weight, and more preferably 2 to 150 parts by weight, relative to 100 parts by weight of the resin component(s) (the total of the thermal radical curable resin component and other resin components).

The amount of other flame retardants in the thermal radical curable resin composition of the present invention is not limited. It is 0 to 100 parts by weight, preferably 1 to 80 parts by weight, and more preferably 10 to 40 parts by weight, relative to 100 parts by weight of the resin component(s) (the total of the thermal radical curable resin component and other resin components).

### Crosslinking Agent

The thermal radical curable resin composition of the present invention can contain a crosslinking agent as long as the effects of the resin composition of the present invention can be exhibited.

Examples of the crosslinking agent include mono(C₆₋₂₀ alkyl)diallyl isocyanurate, 1-benzyl-3,5-diallyl isocyanurate, **1-**(4-vinylbenzyl)-3,5-diallyl isocyanurate, and like monobenzyl diarylisocyanurate, tris(4-vinylbenzyl)isocyanurate, tris(4-vinylbenzyloxy)triazine, triallyl isocyanurate, triallyl cyanurate, diallyl phthalate, diallyl isophthalate, diallyl terephthalate, triallyl trimellitate, and the polyfunctional styrene compounds described above. These compounds may be used singly or in a combination of two or more.

The amount of the crosslinking agent in the thermal radical curable resin composition of the present invention is not limited. It is 0 to 200 parts by weight, preferably 5 to 150 parts by weight, and more preferably 10 to 100 parts by weight, relative to 100 parts by mass of the resin component(s) (the total of the thermal radical curable resin component and other resin components).

The thermal radical curable resin composition of the present invention may further contain other components as necessary. Examples of such other components include the radical polymerization initiators mentioned above, the inorganic fillers mentioned above, stress relief agents, organic solvents, and the additives mentioned above.

### Radical Polymerization Initiator

Examples of usable radical polymerization initiators include the radical polymerization initiators described in the section "3. Resin Composition" above.

The amount of the radical polymerization initiator in the thermal radical curable resin composition of the present invention is not limited. It is 0.001 to 10 parts by weight, preferably 0.01 to 8 parts by weight, and more preferably 0.1 to 5 parts by weight, relative to 100 parts by weight of the resin component(s) (the total of the thermal radical curable resin component and other resin components).

### Inorganic Filler

Examples of usable inorganic fillers include the inorganic fillers described in the section "3. Resin Composition" above.

The amount of the inorganic filler in the thermal radical curable resin composition of the present invention is not limited. It is 0 to 800 parts by weight, preferably 1 to 600 parts by weight, and more preferably 10 to 400 parts by weight, relative to 100 parts by weight of the resin component(s) (the total of the thermal radical curable resin component and other resin components).

### Stress Relief Agent

The stress relief agent to be used is not limited. Examples include silicone resin particles. The stress relief agent preferably has an average particle size of 10 µm or less. The use of a stress relief agent having such an average particle size improves adhesion to metal foil when the thermal radical curable resin composition of the present invention is applied to a metal-clad laminate.

The amount of the stress relief agent in the thermal radical curable resin composition of the present invention is not limited. It is 0 to 100 parts by weight, preferably 0 to 50 parts by weight, relative to 100 parts by mass of the resin component(s) (the total of the thermal radical curable resin component and other resin components).

### Organic Solvent

Any organic solvent can be used as long as it can dissolve or disperse the thermal radical curable resin component. Examples include ketone solvents, such as methyl ethyl ketone (MEK); ether solvents, such as dibutyl ether; ester solvents, such as ethyl acetate; amide solvents, such as dimethylformamide; aromatic hydrocarbon solvents, such as benzene, toluene, and xylene; and chlorinated hydrocarbon solvents, such as trichloroethylene. These solvents may be used singly or in a combination of two or more. The thermal radical curable resin composition of the present invention containing an organic solvent can be used to produce a prepreg by impregnating a base material with the resin composition in the form of a resin varnish, as described below.

The amount of the organic solvent in the thermal radical curable resin composition of the present invention can be adjusted according to the condition of applying the resin varnish to a base material or impregnating a base material with the resin varnish, or both. It is 30 to 1000 parts by weight, preferably 100 to 500 parts by weight, per 100 parts by mass of the resin component(s) (the total of the thermal radical curable resin component and other resin components).

### Additive

Examples of additives include the additives described in the section **"3.** Resin Composition" above.

The amount of the additive in the thermal radical curable resin composition of the present invention is not limited. It is 0 to 50 parts by weight, and preferably 1 to 20 parts by weight, relative to 100 parts by weight of the resin component(s) (the total of the thermal radical curable resin component and other resin components).

The thermal radical curable resin composition of the present invention can be produced by mixing and/or kneading the thermal radical curable resin component and the flame retardant of the present invention, optionally with other resin components, other flame retardants, crosslinking agents, radical polymerization initiators, inorganic fillers, stress relief agents, organic solvents, and additives, by a known method. For example, the thermal radical curable resin composition of the present invention can be produced by mixing and/or kneading a mixture of the components in the form of a liquid, powder, beads, flakes, or pellets using an extruder (e.g., a single-screw extruder, a twin-screw extruder), a kneader (e.g., a Banbury mixer, a pressure kneader, a two-roll mill, a three-roll mill), or the like.

### 5. Use of the Resin Composition of the Present Invention

The resin composition described in section 3 above and the thermal radical curable resin composition described in section 4 above (both collectively referred to below as "the resin composition of the present invention") can be suitably used for applications as prepregs, metal foils with resins, thermosetting resin films, metal-clad laminates, printed wiring boards, resin plates, semiconductor devices, adhesives, and the like.

### Prepreg

The prepreg of the present invention is described below.

When a prepreg to be used for RCC or the like is prepared using the resin composition of the present invention, the resin composition of the present invention can be prepared in a varnish-like form and used as a resin varnish. Such a resin varnish can be prepared, for example, as follows.

First, components that are soluble in an organic solvent (components contained in the resin composition of the present invention) are added to an organic solvent and dissolved. At this time, if necessary, heating may be performed. Thereafter, optional components that are insoluble in an organic solvent (components contained in the resin composition of the present invention), such as an inorganic filler, are added, and the resulting mixture is dispersed using a ball mill, a bead mill, a planetary mixer, a roll mill, or the like until a predetermined dispersion state is achieved, whereby a varnish-like resin composition of the present invention can be prepared.

The prepreg of the present invention comprises the resin composition of the present invention or a semi-cured product of the resin composition of the present invention, and a base material. This semi-cured product refers to a resin composition of the present invention in a partially cured state (B-stage resin composition).

The prepreg of the present invention may be a prepreg comprising a semi-cured resin composition of the present invention (B-stage resin composition) and a base material, or may be a prepreg comprising the resin composition of the present invention before curing (A-stage resin composition) and a base material.

Examples of base materials to be used for the prepreg include glass cloth, aramid cloth, polyester cloth, LCP (liquid crystal polymer) nonwoven fabric, glass nonwoven fabric, aramid nonwoven fabric, polyester nonwoven fabric, pulp paper, and linter paper. Examples of the material for glass cloth include ordinary E-glass, as well as D-glass, S-glass, NE-glass, quartz glass, L-glass, and the like. If glass cloth is used, a laminate with excellent mechanical strength can be obtained. The glass cloth is preferably a flattened glass cloth. The flattening process can be carried out, for example, by continuously pressurizing the glass cloth with press rolls at an appropriate pressure to compress and flatten the yarn. The thickness of the base material is, for example, 0.02 to 0.3 mm.

The proportion of the base material in the prepreg is 20 to 80 wt%, preferably 25 to 70 wt%, of the entire prepreg.

Examples of the prepreg production method include a method in which the resin composition of the present invention is prepared in varnish-like form and then applied to or impregnated into the base material. Examples of methods for impregnation and/or application include a method of immersing a base material (dipping), application method using rolls, die coaters, bar coaters, or the like, and spraying methods using a spray or the like. The impregnation and/or application can be performed multiple times, as necessary. The application or impregnation can also be performed multiple times by using multiple resin compositions having different resin component concentrations, as necessary. After the impregnation or application, drying or heating may be performed.

The base material impregnated with and coated with the resin composition of the present invention is heated at 80 to 180°C for 1 to 10 minutes to obtain a prepreg in a semi-cured state (B-stage resin composition).

Table 1 shows an example of preferred formulations (excluding organic solvents) for the resin composition of the present invention for use as a prepreg. The amounts of the components shown are based on the total of component (A) taken as 100 parts by weight.

**Table 1**

| | | Preferred blending amount of each component) (parts by weight) |
|---|---|---|
| (A) Thermal radical curing resin component ^{(See note.)} | | |
| | Polyphenylene ether resin (product name SA9000-111 available from SABIC or product name OPE-2St available from Mitsubishi Gas Chemical Company, Inc.) | 0 to 100 |
| | Bismaleimide resin (product name BMI-2500 available from Designer Molecules Inc.) | 0 to 100 |
| | Polystyrene resin (product name ODV-XET(X03) available from Nippon Steel Chemical & Material Co., Ltd.) | 0 to 100 |
| (B) Other resin components | | |
| | SBS, SEBS or SEPS | 20 to 40 |
| (C) Flame retardants | | |
| | Flame retardant of the present invention | 30 to 100 |
| | Other flame retardant | 0 to 30 |
| (D) Radical polymerization initiator | | |
| | α,α'-Di(t-butylperoxy)diisopropylbenzene | 0.1 to 5 |
| (E) Crosslinking agent | | |
| | Triallyl isocyanurate or 1-dodecyl-3,5-diallylisocyanurate | 0 to 50 |

| | | |
|---|---|---|
| Note: The total amount of component (A) is 100 parts by weight. | | |

The use of such a prepreg enables the production of a metal-clad laminate and a printed wiring board that have excellent electrical properties (e.g., dielectric properties), heat resistance, flame retardancy, adhesive strength, and chemical resistance.

### Metal Foil with Resin

The metal foil with resin of the present invention is described below.

The metal foil with resin of the present invention comprises a resin layer containing the resin composition of the present invention or a semi-cured product of the resin composition of the present invention; and metal foil.

The metal foil with resin of the present invention has a metal foil on the surface of a resin layer containing the resin composition of the present invention or a semi-cured product of the resin composition of the present invention. Further, the metal foil with resin of the present invention may have another layer between the resin layer and the metal foil.

As described above, the resin layer may be a semi-cured product of the resin composition of the present invention (B-stage resin composition), or may be the resin composition of the present invention before curing (A-stage resin composition). The resin layer may or may not comprise a base material. The base material may be the same as that of the prepreg.

The metal foil may be, for example, copper foil or aluminum foil. The thickness of the copper foil is, for example, about 12 to 70 µm.

The method for producing the metal foil with resin of the present invention includes, for example, a method comprising applying to metal foil the resin composition of the present invention prepared in a varnish-like form as described above. The coating method is not limited as long as it is a method that can apply the resin composition of the present invention to a metal foil. Examples include methods of application using a roll, a die coater, a bar coater, or the like, and methods of spraying with a sprayer or the like. After the application, drying and heating may be performed.

The metal foil coated with the resin composition of the present invention can be heated at 80 to 180°C for 1 to 10 minutes to obtain metal foil with resin in a semi-cured state (B-stage resin composition).

Examples of preferred formulations (excluding organic solvents) for the resin composition of the present invention to be used as metal foil with resin comprising a base material are the same as those for the resin composition of the present invention to be used as a prepreg described above (see Table 1 above). Table 2 shows an example of preferred formulations (excluding organic solvents) for the resin composition of the present invention to be used as metal foil with resin that does not comprise a base material. The amount of each component is expressed based on the total of component (A) taken as 100 parts by weight.

**Table 2**

| | | Preferred blending amount (parts by weight) |
|---|---|---|
| (A) Thermal radical curing resin component ^{(See note.)} | | |
| | Polyphenylene ether resin (product name SA9000-111 available from SABIC or product name OPE-2St available from Mitsubishi Gas Chemical Company, Inc.) | 0 to 100 |
| | Bismaleimide resin (product name BMI-2500 available from Designer Molecules Inc.) | 0 to 100 |
| | Polystyrene resin (product name ODV-XET(X03) available from Nippon Steel Chemical & Material Co., Ltd.) | 0 to 100 |
| (B) Other resin components | | |
| | SBS | 10 to 200 |
| | SEBS, SEPS | 10 to 200 |
| (C) Flame retardant | | |
| | Flame retardant of the present invention | 10 to 150 |
| (D) Radical polymerization initiator | | |
| | α,α'-Di(t-butylperoxy)diisopropylbenzene | 0.1 to 2 |
| (E) Inorganic filler | | |
| | Silica | 10 to 300 |
| (F) Crosslinking agent | | 0 to 50 |
| | Triallyl isocyanurate or 1-dodecyl-3,5-diallylisocyanurate | |

| | | |
|---|---|---|
| Note: The total amount of component (A) is 100 parts by weight. | | |

The use of such a metal foil with resin enables the production of a metal-clad laminate and a printed wiring board that have excellent electrical properties (e.g., dielectric properties), heat resistance, flame retardancy, adhesive strength, and chemical resistance.

### Thermosetting Resin Film

The thermosetting resin film of the present invention is described below.

The thermosetting resin film of the present invention can be produced by forming the resin composition of the present invention into a desired shape. For example, the thermosetting resin film of the present invention can be produced by applying the resin composition of the present invention to a support and then drying.

The support is not particularly limited. Examples include metal foil, such as copper or aluminum foil, and organic films, such as polyester resin, polyethylene resin, or polyethylene terephthalate resin (PET) films. The support may be subjected to a release treatment using a silicone compound or the like. The resin composition of the present invention can be used in various shapes, and the shape is not particularly limited.

The method for applying the resin composition of the present invention to a support is not limited. From the viewpoint of thinning the film and controlling the film thickness, for example, a gravure method, a slot die method, and a doctor blade method are preferable. The slot die method allows for the production of an uncured film of the resin composition with a thickness that will result in a thickness of 5 to 300 µm after curing (thermosetting resin film of the present invention).

The drying conditions can be appropriately set according to the type and amount of organic solvent used in the resin composition of the present invention, the thickness of the coating, etc. The conditions can be, for example, 50 to 120°C for 1 to 60 minutes. The thermosetting resin film of the present invention thus obtained has good storage stability. The thermosetting resin film can be peeled off from the support at any desired time.

The thermosetting resin film of the present invention can be cured, for example, at 150 to 230°C for 30 to 180 minutes. The thermosetting resin film of the present invention may be cured after the thermosetting resin film is sandwiched between base materials on which wiring has been formed of copper foil or the like, or after a thermosetting resin film on which wiring has been formed of copper foil or the like is stacked appropriately. The thermosetting resin film can also be used as a coverlay film to protect wiring on a base material. The curing conditions used in this case are also similar.

Further, the thermosetting resin film of the present invention can be suitably used as a flexible copper clad laminate (FCCL) for a flexible printed wiring board (FPC), a copper clad laminate (CCL) for a multilayer board, or a build-up material.

Table 3 shows an example of preferred formulations (excluding an organic solvents) for the resin composition of the present invention to be used as the thermosetting resin film. The amount of each component is based on 100 parts by weight of the total of component (A). When an organic solvent is added, it is preferably added appropriately so that the viscosity falls within the range of 200 to 3000 mPa·s.

**Table 3**

| | | Preferred blending amount (parts by weight) |
|---|---|---|
| (A) Thermal radical curing resin component ^{(See note.)} | | |
| Polyphenylene ether resin (product name SA9000-111 available from SABIC or product name OPE-2St available from Mitsubishi Gas Chemical Company, Inc.) | | 0 to 100 |
| Bismaleimide resin (product name BMI-2500 available from Designer Molecules Inc.) | | 0 to 100 |
| Polystyrene resin (product name ODV-XET(X03) available from Nippon Steel Chemical & Material Co., Ltd.) | | 0 to 100 |
| (B) Other resin components | | |
| | SBS, SEBS or SEPS | 40 to 80 |
| (C) Flame retardant | | |
| | Flame retardant of the present invention | 30 to 100 |
| (D) Radical polymerization initiator | | |
| | α,α'-Di(t-butylperoxy)diisopropylbenzene | 0.1 to 4 |
| (E) Additive | | |
| | Silane coupling agent | 1 to 10 |
| (F) Crosslinking agent | | |
| | Triallyl isocyanurate or 1-dodecyl-3,5-diallylisocyanurate | 0 to 50 |

| | | |
|---|---|---|
| Note: The total amount of component (A) is 100 parts by weight. | | |

### Metal-clad Laminate

The metal-clad laminate of the present invention is explained below.

The metal-clad laminate of the present invention comprises an insulation layer comprising a cured product of the resin composition of the present invention and a metal foil. The metal-clad laminate comprises a metal foil on a surface of an insulation layer. The metal-clad laminate may also include one or more other layers between the insulation layer and the metal foil.

The insulation layer may or may not comprise a base material. The base material may be the same as that of the prepreg. As the metal foil, the same metal foil as that of the resin-coated metal foil can be used.

The method for producing a metal-clad laminate can be, for example, a method using the prepreg described above. The method for producing a metal-clad laminate by using the prepreg is, for example, a method comprising stacking at least one prepreg, further stacking a metal foil, such as copper foil, on both sides or one side of the prepreg, and then heating and press-molding the stack of layers to form an integrated laminate. This method allows the production of a laminate with metal foil cladding on one side or on both sides of the laminate.

The heating and pressing conditions can be appropriately set depending on the thickness of the metal-clad laminate to be produced and the formulation of the resin composition used in the prepreg. For example, the conditions can be a temperature of 170 to 220°C, a pressure of 1.5 to 5.0 MPa, and a time of 60 to 150 minutes.

The metal-clad laminate can also be produced without using prepregs. Examples of such methods include a method comprising applying the varnish-like resin composition of the present invention to metal foil, forming a layer containing the resin composition of the present invention on the metal foil, and then heating and applying pressure, and a method comprising curing a thermosetting resin film using metal foil as a support.

Examples of preferred formulations (excluding an organic solvent) for the resin composition of the present invention to be used as a metal-clad laminate comprising a base material are the same as those for the resin composition to be used as a prepreg described above (see Table 1 above). Examples of preferred formulations (excluding organic solvents) for the resin composition of the present invention to be used as a metal-clad laminate not comprising a base material are the same as those for the resin composition to be used as a metal foil with resin not comprising a base material (see Table 2 above).

The use of such a metal-clad laminate enables the production of a printed wiring board with excellent electrical properties (e.g., dielectric properties), heat resistance, flame retardancy, adhesive strength, and chemical resistance.

### Printed Wiring Board

The printed wiring board of the present invention is described below.

The printed wiring board of the present invention comprises an insulation layer comprising a cured product of the resin composition of the present invention or a cured product of the thermosetting film of the present invention; and wiring. The printed wiring board of the present invention has wiring on the surface of the insulation layer. Further, the printed wiring board of the present invention may have one or more other layers between the insulation layer and the wiring.

The insulation layer may or may not comprise a base material. The base material can be the same material as that of the prepreg.

The printed wiring board of the present invention has an insulation layer comprising a cured product of the resin composition of the present invention or a cured product of the thermosetting resin film of the present invention, and thus has excellent electrical properties (e.g., dielectric properties, etc.) and high flame retardancy.

The wiring is not particularly limited as long as it can be provided on a printed wiring board. For example, wiring may be formed by partially removing the metal foil stacked on the insulation layer. Examples of the wiring include wiring formed by a subtractive method, an additive method, a semi-additive method, chemical mechanical polishing (CMP), a trench method, an inkjet method, a squeegee method, a transfer method, and the like.

The method for producing a printed wiring board is, for example, a method using a metal-clad laminate such as those described above. The method for producing a printed wiring board using the metal-clad laminate is, for example, a method in which the metal foil on the surface of a metal-clad laminate is etched or processed otherwise to form a circuit. A printed wiring board in which a conductor pattern is formed as a circuit on the surface of a metal clad laminate can be obtained by this method.

A preferred example of formulations (excluding organic solvents) for the resin composition of the present invention to be used as a printed wiring board comprising a base material in the insulation layer is the same as that for the resin composition to be used as a prepreg described above (see Table 1 above). Examples of preferred formulations (excluding organic solvents) for the resin composition of the present invention to be used as a printed wiring board containing an insulation layer not comprising a base material are the same as those for the resin composition to be used as copper foil with resin not comprising a base material described above (see Table 2 above).

The printed wiring board obtained in this manner has excellent electrical properties (for example, dielectric properties), heat resistance, flame retardancy, and chemical resistance, and is sufficiently inhibited from peeling of the circuit. Furthermore, even in the form of a package with semiconductor chips being bonded, the printed wiring board is easy to mount, has consistent quality, and is also excellent in signal speed and impedance.

### Resin Plate

The resin composition of the present invention can be used as a resin plate prepared by curing the resin composition to form a plate shape. For example, a resin plate obtained by applying a varnish-like resin composition of the present invention to form a plate, drying, and then curing the dried coating. Examples of the resin plate include an unclad plate obtained by removing the metal foil of the metal-clad laminate.

### Semiconductor Device

The case of using the resin composition of the present invention in semiconductor devices is described below.

The semiconductor device can be produced by using the resin composition of the present invention or the thermosetting resin film of the present invention and curing the composition or the film. This semiconductor device has excellent electrical properties (e.g.**,** dielectric properties) and high flame retardancy based on the cured product of the resin composition of the present invention or the cured product of the thermosetting resin film of the present invention, thus being suitable for high-frequency applications.

A semiconductor device refers to any device that functions by utilizing semiconductor properties. Examples of semiconductor devices include electronic components, semiconductor circuits, modules incorporating these components and circuits, and electronic equipment.

### Adhesive

The adhesive of the present invention is described below.

The adhesive of the present invention contains the resin composition of the present invention as a component. The adhesive of the present invention can be used as an adhesive between two materials selected from metals, inorganic materials, and resin materials. The adhesive of the present invention is particularly preferable as an adhesive between a metal and a material selected from metals, inorganic materials, and resin materials.

Examples of the metal include copper, aluminum, titanium, nickel, tin, iron, silver, gold, and alloys thereof. Among these metals, copper is preferred. The form of the metal includes, for example, plates, foils, and plating films of these metals.

Examples of inorganic materials include silicon, ceramics, carbon used as a filler, inorganic salts, and glass. Specific examples include silicon compounds, such as silicon, silicon carbide, silica, glass, diatomaceous earth, calcium silicate, talc, glass beads, sericite activated clay, bentonite, aluminosilicates, and mica; oxides, such as alumina, zinc oxide, iron oxide, magnesium oxide, tin oxide, and titanium oxide; hydroxides, such as magnesium hydroxide, aluminum hydroxide, and basic magnesium carbonate; carbonates, such as calcium carbonate, zinc carbonate, hydrotalcite, and magnesium carbonate; sulfates, such as barium sulfate and gypsum; titanates, such as barium titanate; nitrides, such as aluminum nitride and silicon nitride; graphites, such as flake graphite (natural graphite), expandable graphite, and expanded graphite (synthetic graphite); activated carbons; carbon fibers; and carbon black.

Among these inorganic materials, silicon, ceramics (alumina, silicon carbide, aluminum nitride, silicon nitride, barium titanate, etc.), glass, and inorganic salts are preferred.

Examples of resin materials include nylons, acrylate resins, epoxy resins, olefin resins, benzoxazine resins, polybenzoxazole resins, silicone resins, polyamide resins, polyimide resins, bismaleimide resins, maleimide resins, cyanate resins, polyphenylene ether resins, polyphenylene oxide resins, fluorine-containing resins, polyether resins, polyetherimide resins, polyetheretherketone resins, polyester resins, silicone resins, liquid crystal resins, and the like. These may be used in combination by mixing them or modifying them with each other.

Among these resin materials, acrylate resins, epoxy resins, olefin resins, benzoxazine resins, polybenzoxazole resins, bismaleimide resins, polyphenylene ether resins, fluorine-containing resins, polyether resins, liquid crystal resins, silicone resins, and polyimide resins are preferred.

As the method for bonding a material using an adhesive, known methods can be used. Specific examples include (1) a method comprising applying an adhesive to the surface of a material selected from metals, inorganic materials, and resin materials, pressure-bonding another material to a part or the entirety of the adhesive applied, and bonding the material (by curing the adhesive); and (2) a method comprising forming a semi-cured adhesive into a sheet and attaching the sheet to the surface of a material selected from metals, inorganic materials, and resin materials, and pressure-bonding another material to a part or the entirety of the other side of the adhesive to bond the material (by curing the adhesive).

The adhesive can be cured by a known method. Examples of the method include a method comprising heating and applying pressure using a heat press, and a method comprising first drying an adhesive applied and then performing a heat treatment. The conditions for heating and pressurization are, for example, a temperature of 50 to 300°C (in particular, 80 to 250°C) under a pressure of 0.1 to 50 MPa (in particular, 0.5 to 10 MPa) for about 1 minute to 10 hours (in particular, about 30 minutes to about 5 hours).

Since two materials, in particular, two different kinds of materials, can be bonded by using the adhesive of the present invention as described above, the adhesive of the present invention can be suitably used for electronic devices, such as various electric or electronic components, semiconductor wafers, printed wiring boards, and flexible metal-clad laminates.

Examples of preferred formulations (excluding organic solvents) for the resin composition of the present invention to be used as an adhesive are the same as those for the thermosetting resin film described above (see Table 3 above).

In the present specification, the term "comprise" or "have" also includes the concepts of consisting essentially of and consisting of.

### Examples

Examples are given below to illustrate the present invention in more detail. However, the present invention is not limited to these Examples.

The main ingredients used in the Synthesis Examples are as follows:
Main Ingredients
- 2-Vinylphenol (see chemical formula (II-1)); synthesized according to the method described in Organic Letters (2012), 14(18), 4722-4725)
- Phosphoryl chloride (see chemical formula (III); available from Fujifilm Wako Pure Chemical Industries, Ltd.)
- Pyridine (available from Fujifilm Wako Pure Chemical Corporation)
- Toluene (available from Fujifilm Wako Pure Chemical Corporation)

The main ingredients used in the Examples are as follows:
Main Ingredients
(i) Thermal Radical Curable Resin Component
   - Methacrylic modified polyphenylene ether (available from SABIC, polyphenylene ether resin, product name SA9000-111, molecular weight: 2300)
(ii) Other Resin Components
   - Styrene-butadiene-styrene block copolymer (product name: Tufprene A, available from Asahi Kasei Corporation, a styrene-based block copolymer, styrene/butadiene weight ratio = 40/60)
(iii) Flame Retardant
   - Tris(2-vinylphenyl)phosphate (see chemical formula (I-1), Synthesis Example 1; referred to below as "flame retardant 1")
   - Tris(4-vinylphenyl)phosphate (see chemical formula (V); synthesized according to the method described in CN109762115A; referred to below as "flame retardant 2")
   - Tris(2-allylphenyl)phosphate (see chemical formula (VI), synthesized according to the method described in CN109762115A; referred to below as "flame retardant 3")
   - Triallyl isocyanurate (see chemical formula (VIII), available from Tokyo Chemical Industry Co., Ltd.; referred to below as "flame retardant 4"). 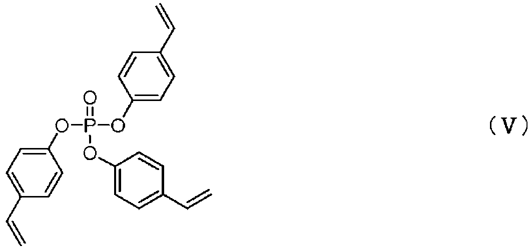 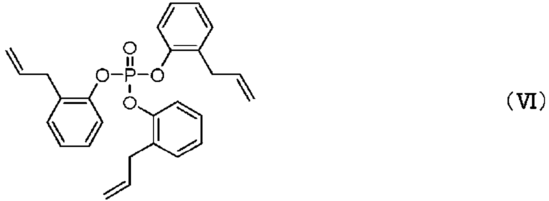 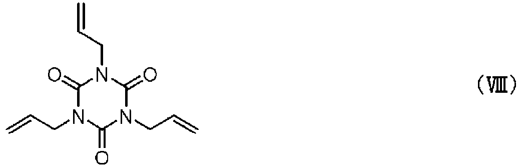
(iv) Radical Polymerization Initiator
   - α,α'-di(t-butylperoxy)diisopropylbenzene (available from Nippon Oil & Fats, product name Perbutyl P)
(v) Organic Solvent
   - Toluene (available from Fujifilm Wako Pure Chemical Corporation)

The evaluation tests used in Examples and Comparative Examples (evaluation method for flame retardancy, measurement method for glass transition temperature, and measurement method for dielectric properties) are as follows:

### Evaluation of Flame Retardancy

Each resin composition was applied onto a 25 µm-thick polyimide film with a bar coater so that the resulting coating film had a thickness of 50±5 µm after drying, and toluene was evaporated until a constant weight was achieved. Subsequently, the obtained product was subjected to a heat treatment at 150°C for 30 minutes and at 190°C for 1 hour to obtain a film for evaluation. The evaluation film thus obtained was evaluated for flame retardancy according to the UL94 VTM test method, which is a vertical flame test of the **U.S.** UL standard.

### Measurement of Glass Transition Temperature (Tg)

Each resin composition was poured into a mold set to a thickness of 1 mm by using a 1 mm-thick silicon spacer, and the mold was then placed in a blower oven heated at 80°C to evaporate toluene until a constant weight was achieved. The resulting mixture was then heated at 120°C for 30 minutes, at 150°C for 30 minutes, and at 190°C for 1 hour to obtain a plate-like cured product having a thickness of 1 mm.

A test piece with a length of 20 mm, a width of 5 mm, a thickness of 1 mm was cut out from this cured product and fixed to solid torsion jigs of a dynamic mechanical analyzer (DMA) (Rheosol-G5000 available from UBM), and its dynamic viscoelasticity was measured in a temperature range of 50 to 300°C at a temperature-rise rate of 5°C/min, a frequency of 1 Hz, and a strain of 0.08%. The glass transition temperature (unit: °C) was defined as the peak top temperature of loss modulus.

The higher the glass transition temperature, the better the heat resistance of the cured product is judged to be.

The materials having a glass transition temperature of 230°C or higher were evaluated as "A", those having a temperature of 150°C or more and less than 230°C as "B", and those below 150°C as "C."

### Measurement of Dielectric Properties (Dielectric Tangent: Df)

Each resin composition was poured into a mold set to a thickness of 1 mm by using a 1 mm-thick silicon spacer, and the mold was then placed in a blower oven heated at 80°C to evaporate toluene until a constant weight was achieved. The resulting composition was then heated at 120°C for 30 minutes, at 150°C for 30 minutes, and at 190°C for 1 hour to obtain a plate-shaped cured product with a thickness of 1 mm.

A test piece with a length of 50 mm, a width of 2 mm, and a thickness of 1 mm was cut out from each cured product thus obtained and dried at 200°C for 3 hours. The dielectric properties (dielectric tangent Df) of each test piece were measured at a measurement frequency (10 GHz) by the cavity resonance method using a network analyzer (E8361A; available from Agilent Technologies).

The smaller the dielectric tangent (Df), the better the dielectric property of the cured product is judged to be.

### Synthesis Example 1

### Synthesis of Tris(2-vinylphenyl)phosphate

52.06 g (433.3 mmol) of 2-vinylphenol and 247.6 mL of pyridine were placed in a 1000 mL reactor, and cooled to 0°C with stirring. Subsequently, while the temperature was maintained at 0 to 5°C, 18.61 g (121.4 mmol) of phosphoryl chloride was added dropwise over 2 hours. The temperature was then raised to 25°C and the mixture was stirred for 1 hour. The temperature was then raised to 100°C and the mixture was stirred for 14 hours. Subsequently, the mixture was cooled to room temperature, and toluene was added to reaction mixture. The resulting mixture was washed with water and the organic layer was concentrated. The obtained concentrate was purified by column chromatography (toluene/hexane = 2/1 (volume ratio)) to obtain 44.3 g of a pale-yellow liquid (yield: 90.2%).

The ¹H-NMR spectrum data of the pale-yellow liquid were as follows:
. ¹H-NMR (CDCl₃) &: 7.54-7.57 (m, 3H), 7.35-7.39 (m, 3H), 7.21-7.26 (m, 3H), 7.15-7.20 (m, 3H), 6.86 (dd, 3H), 5.71 (dd, 3H), 5.24 (dd, 3H).

The IR spectrum data of the pale-yellow liquid were as shown in the chart of Fig. 1.

From these spectral data, the obtained pale-yellow liquid was identified as the compound represented by chemical formula (I-1).

### Example 1

A thermal radical curable resin composition was prepared by mixing 4.88 parts by weight of SA9000-111 as a thermal radical curable resin component, 1.52 parts by weight of Tufprene A as another resin component, 3.60 parts by weight of the phosphorus compound obtained in Synthesis Example 1 as a flame retardant, 0.12 parts by weight of Perbutyl P as a radical polymerization initiator, and 10.12 parts by weight of toluene as an organic solvent.

The resin composition was subjected to evaluation tests (flame retardancy evaluation, glass transition temperature measurement, and measurement of dielectric properties). Table 4 shows the obtained test results.

### Comparative Examples 1 to 4

Resin compositions having the formulations shown in Table 4 were prepared in the same manner as in Example 1. The resin compositions were subjected to evaluation tests. Table 4 shows the obtained test results.

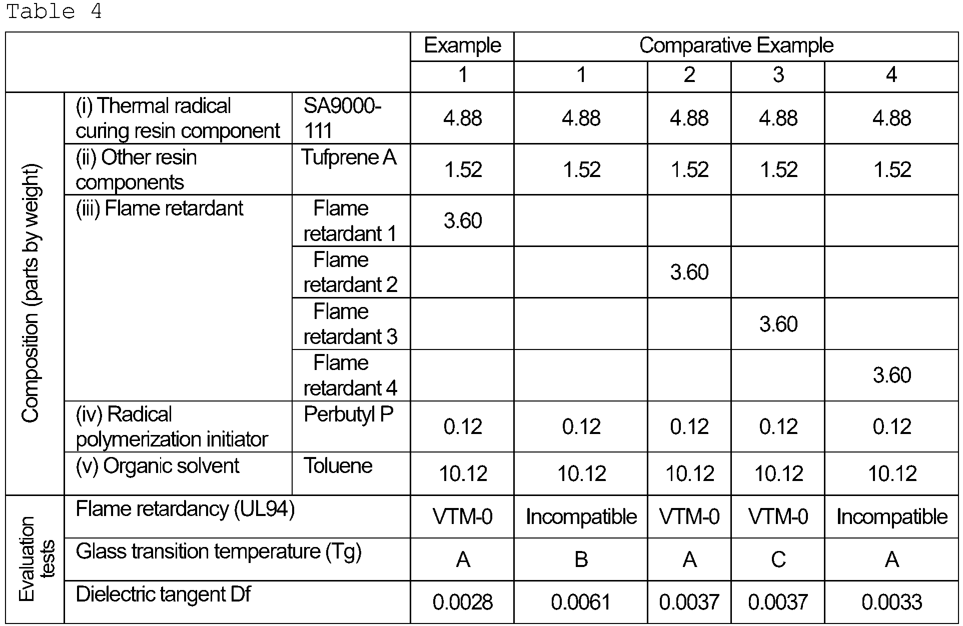

It was confirmed from Table 4 that when flame retardant 1 was used as a flame retardant (Example 1), the cured product had high flame retardancy, a high glass transition temperature (Tg), and a low dielectric tangent (Df), as compared to those achieved by using no flame retardant (Comparative Example 1) or using a conventional flame retardant (Comparative Examples 2 to 4). Accordingly, a resin composition that contains the flame retardant of the present invention is considered to provide a cured product with excellent flame retardancy, heat resistance, and electrical properties.

### Industrial Applicability

The resin composition that contains the flame retardant of the present invention provides a cured product with excellent flame retardancy, heat resistance, and electrical properties, and is thus suitable as a material for printed wiring boards, adhesives, etc.

## Claims

1. A flame retardant comprising a phosphorus compound represented by chemical formula (I): 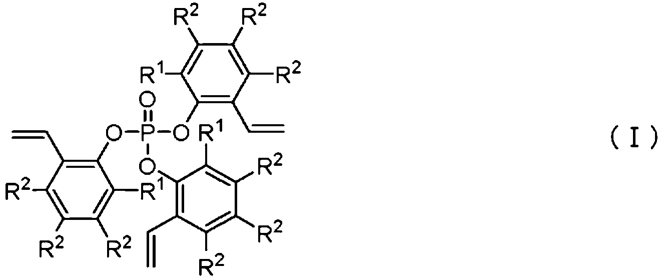 wherein each R¹ is the same or different and represents a hydrogen atom or a C₁₋₁₀ alkyl group, and each R² is the same or different and represents a hydrogen atom or a C₁₋₁₀ alkyl group.

2. A resin composition comprising:
the flame retardant according to claim 1; and
a resin component.

3. A prepreg comprising:
the resin composition according to claim 2; and
a base material.

4. A metal foil with resin comprising:
a resin layer containing the resin composition according to claim 2 or a semi-cured product of the resin composition; and
metal foil.

5. A thermosetting resin film formed from the resin composition according to claim 2.

6. A metal-clad laminate comprising:
an insulation layer containing a cured product of the resin composition according to claim 2; and
metal foil.

7. A printed wiring board comprising:
an insulation layer containing a cured product of the resin composition according to claim 2 or a cured product of the thermosetting resin film according to claim 5; and
a wire.

8. An adhesive containing the resin composition according to claim 2 as a component.
